# EUROPÄISCHE PATENTSCHRIFT

(11) **EP 3 278 121 B1**
(45) Veröffentlichungstag und Bekanntmachung des Hinweises auf die Patenterteilung: **30.09.2020**
(21) Anmeldenummer: 16717542.1
(22) Anmeldetag: 23.03.2016
(51) Int. Cl.: G01R 15/18, H01R 13/514, H01R 13/66

(54) **SENSORMODUL EINES MODULAREN STECKVERBINDERS**
SENSOR MODULE OF A MODULAR PLUG CONNECTOR
MODULE DÉTECTEUR D'UN CONNECTEUR ENFICHABLE MODULAIRE

(30) Priorität: 30.03.2015 DE 102015104838
(43) Veröffentlichungstag der Anmeldung: 07.02.2018
(73) Patentinhaber: Harting Electric GmbH & Co. KG, 32339 Espelkamp (DE)
(72) Erfinder: TRÖGER, Lutz, 49082 Osnabrück (DE)
(86) Internationale Anmeldenummer: PCT/DE2016/100137
(87) Internationale Veröffentlichungsnummer: WO 2016/155702

(56) Entgegenhaltungen:
- EP-A1- 2 369 693
- EP-A2- 2 568 300
- DE-A1- 4 435 864
- DE-U1-202007 018 306
- US-A1- 2007 025 065

## Beschreibung

Die Erfindung betrifft ein Sensormodul für einen modularen Steckverbinder.

Modularer Steckverbinder werden insbesondere im Maschinen- und Anlagenbau eingesetzt.

### Stand der Technik

Ein modularer Steckverbinder ist beispielsweise aus der EP 1 353 412 A2 bekannt. Über derartige Steckverbinder werden eine Reihe von verschiedenen Datensignalen und Strömen geleitet. In derartigen Steckverbindern herrscht oft Platzmangel.

Die US 2008/0048646 A1 und DE 10 2007 035 184 A1 zeigen jeweils scheibenförmige Stromsensoren mit einer mittigen Durchführung für ein Kabel.

Die US-2011/0148561 A1 zeigt einen ringförmigen Sensor, der aus einzelnen Spulensegmenten zusammengesetzt ist.

Die DE 20 2007 018 306 U1 zeigt einen modularen Steckverbinder mit einem Modul 6, welches als Messeinrichtung ausgestaltet ist.

Die EP 2 568 300 A2 zeigt ein Sensorgerät zur Strommessung von Kabeln. Das Sensorgerät setzt sich aus einem Gehäuse zusammen, in welchem mehrere Spulenträger ringförmig angeordnet sind

Die DE 20 2077 018 306 U1 zeigt ein Steckverbindermodul für modulare Steckverbinder. In dem Steckverbindermodul ist ein Sensor integriert, der bspw. Strom, Spannung, Temperatur, etc. messen kann.

Die DE 44 35 864 A1 zeigt eine Steckbuchse mit einem aus Gießharz bestehenden Isolierkörper in welchen ein Stromsensor, in Form einer Rogowski-Spule, eingebettet ist.

Die US 2007/0025065 A1 zeigt einen Stromsensor mit einem im Wesentlichen C-förmig gebogenen Gehäuse.

Um beispielsweise Maschinen oder Anlagen besser überwachen zu können, wäre es grundsätzlich von Vorteil, wenn die in die Maschine oder Anlage eingehenden Signale und/oder Ströme überwachbar wären. Davon könnten beispielsweise Vorhersagen über den Zustand einer Maschine abgeleitet werden.

### Aufgabenstellung

Die Aufgabe der Erfindung besteht darin, ein Sensorelement für einen modularen Steckverbinder vorzuschlagen, welches platzsparend eingesetzt werden kann und dennoch effektiv arbeitet.

Die Aufgabe wird durch ein Sensormodul für einen modularen Steckverbinder mit den Merkmalen des unabhängigen Anspruchs 1 gelöst.

Vorteilhafte Ausgestaltungen der Erfindung sind in den Unteransprüchen angegeben.

Das erfindungsgemäße Sensormodul ist zum Einsatz in einem modularen Steckverbinder vorgesehen. Derartige Steckverbinder enthalten in der Regel einen so genannten Gelenkrahmen, in welchen mehrere, oft unterschiedliche, Module einsetzbar sind. Die Anzahl der Plätze für Module im Gelenkrahmen ist begrenzt. Das hier vorgeschlagene Sensormodul besteht aus einem Kernsegment und zumindest zwei darum angeordneten Außensegmenten. Im zusammengesetzten Zustand schließen die Segmente miteinander einen Hohlraum ein.

In einer vorteilhaften Ausführungsform ist das Sensormodul aus einem hantelförmigen Kernsegment und vier darum angeordneten Außensegmenten gebildet. Die einzelnen Segmente bestehen in der Regel aus Kunststoff und sind fertigungstechnisch leicht herstellbar.

Vorzugsweise ist der Hohlraum, den die Segmente miteinander einschließen torusförmig. Diese Torusform ist besonders dazu geeignet ein Bauteil eines Sensors aufzunehmen.

Die Torusform wird vorzugsweise dadurch erreicht, dass die Außensegmente eine zum Kernsegment gerichtete Einwölbung aufweisen, auf deren Oberflächen jeweils mehrere Leiterbahnen aufgebracht sind, wobei auf der Mantelfläche des Kernsegments mehrere Leiterbahnen aufgebracht sind.

Vorzugsweise weisen die einzelnen Leiterbahnen jeweils Kontaktstellen auf, über welche eine Leiterbahn eines Segments mit zumindest einer Leiterbahn eines anderen Segments elektrisch verbindbar ist. Diese Kontaktstellen können beispielsweise wie Lötpads auf einer Leiterplatte ausgestaltet sein. Wenn alle Leiterbahnen, über die Kontaktstellen verbunden sind, wird die Form einer so genannten Ringspule ausgebildet.

Vorteilhafterweise weisen die einzelnen Leiterbahnen jeweils zwei Kontaktstellen auf und eine Leiterbahn eines Segments ist mit zumindest zwei Leiterbahnen eines anderen Segments elektrisch verbunden. Dadurch wird die Form der Ringspule erreicht.

Vorzugsweise sind die Kontaktstellen flächig ausgebildet beziehungsweise ausgestaltet. Die jeweiligen Kontaktstellen weisen einen größeren Flächeninhalt auf als der Flächeninhalt der Querschnittsfläche der jeweiligen Leiterbahnen. Die Kontaktstellen dienen zur elektrischen Verbindung der Leiterbahnen der Segmente. Die Kontaktstellen müssen elektrisch miteinander verbunden sein. Insofern ist eine große Verbindungsfläche vorteilhaft. Um die Vorteile der MID Technologie auszunutzen, könnte man sich einen kontakt vorstellen, der einen Art V-förmigen Trog darstellt, in den ein Zylinder oder ein ebenfalls V-förmiger Kontakt eingepresst wird. Technisch am besten ist es, wenn der Kontakt keine Änderung des effektiven Leistungsdurchmessers darstellt, um keinen Impedanzsprung zu erzeugen.

In einer vorteilhaften Ausgestaltung der Erfindung sind die sich berührenden Kontaktstellen der Segmente mit einem elektrisch leitfähigen Kleber miteinander verklebt. Über diese Verklebung werden beispielsweise gleichzeig auch die Segmente miteinander verbunden. Hier können aber auch noch weitere Verbindungstechniken hinzutreten.

Besonders bevorzugt sind die Leiterbahnen mithilfe der MID-Technik erzeugt. Der MID-fähige Kunststoff kann sehr leicht im Spritzgussverfahren in die erforderliche Segmentform gebracht werden. Der Beschichtungsprozess der Leiterbahnen ist bei derartigen Segmentformen ebenfalls leicht durchführbar. Eine geeignete MID-Technik zur Erzeugung der Leiterbahnen wird beispielsweise in der DE 10 2006 041 610 B3 beschrieben.

In einer vorteilhaften Ausgestaltung der Erfindung weist zumindest ein Außensegment zumindest einen Durchgang auf, wobei der Durchgang vom Hohlraum zu einer Austrittsfläche einer Außenfläche des Außensegments verläuft. In der Regel werden zwei solche Durchgänge vorgesehen sein.

Da die Ringspule Teil einer Sensorschaltung ist, muss die Ringspule elektrisch abgreifbar sein. Das bedeutet, die Ringspule muss elektrisch kontaktierbar sein. Über die Durchgänge kann die im Sensormodul eingeschlossene Ringspule elektrisch abgegriffen werden. Dazu ist der Durchgang mit elektrisch leitenden Material beschichtet ist oder er enthält elektrisch leitendes Material. Über den Durchgang besteht eine elektrisch leitende Verbindung zwischen einer Leiterbahn, und im Ganzen gesehen zu der Ringspule, und der Austrittsfläche. Die Austrittsfläche kann beispielsweise wie ein Lötpad auf einer Leiterplatte ausgestaltet sein.

Vorzugsweise wird die Ringspule im Sensormodul in einer so genannten Rogowski-Anordnung zur Messung von Wechselströmen verwendet.

### Ausführungsbeispiel

Ein Ausführungsbeispiel der Erfindung ist in den Zeichnungen dargestellt und wird im Folgenden näher erläutert. Es zeigen:
- Fig. 1: eine perspektivische Explosionszeichnung eines Sensormoduls,
- Fig. 2: a) eine perspektivische Darstellung eines Außensegments, b) eine perspektivische Darstellung eines Kernsegments,
- Fig. 3: eine perspektivische Darstellung des Kernsegments mit zwei verbundenen Außensegmenten,
- Fig. 4: eine perspektivische Darstellung des Sensormoduls mit transparent dargestellten Außensegmenten und
- Fig. 5: eine elektrische Schaltskizze.

Die Figuren enthalten teilweise vereinfachte, schematische Darstellungen. Zum Teil werden für gleiche, aber gegebenenfalls nicht identische Elemente identische Bezugszeichen verwendet. Verschiedene Ansichten gleicher Elemente könnten unterschiedlich skaliert sein.

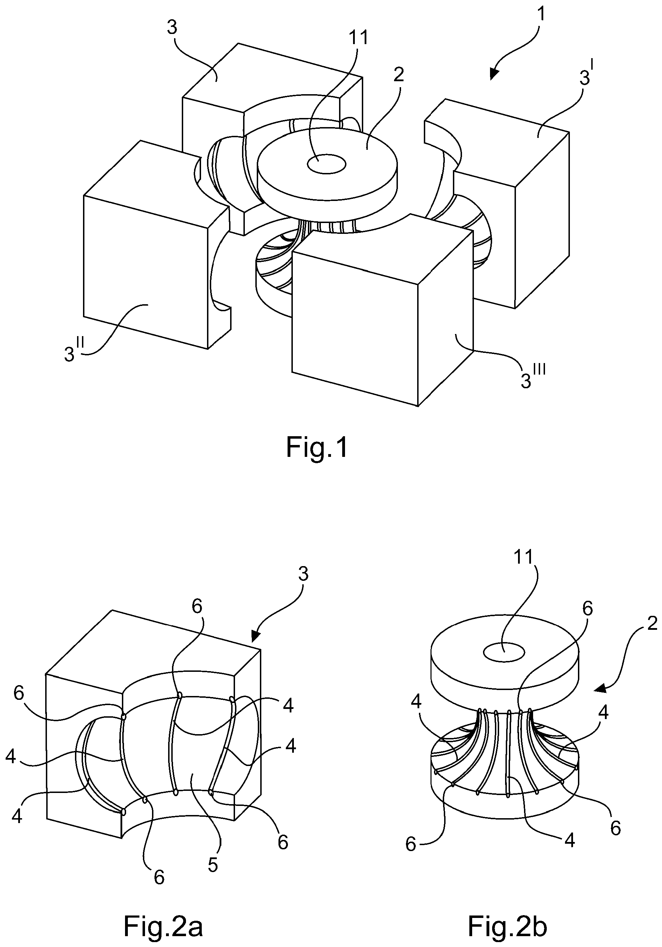

Die Figur 1 zeigt eine perspektivische Explosionszeichnung eines erfindungsgemäßen Sensormoduls 1. Ein Kernsegment 2 ist von vier Außensegmenten 3, 3', 3", 3'" umgeben. Ein Außensegment 3 ist noch einmal separat in Figur 2a gezeigt. In Figur 2b ist ein einzelnes Kernsegment 2 zu sehen.

Das Kernsegment 2 hat im Wesentlichen eine hantelförmige Form. Entlang der Mantelfläche sind in axialer Richtung Leiterbahnen 4 aufgebracht. Das Außensegment 3 hat im Wesentlichen die Form eines Würfels oder Kubus, wobei bei einer Kante ein Kreissegment ausgeschnitten ist. Im Bereich dieses Ausschnitts ist das Außensegment außerdem eingewölbt. Auf der Oberfläche der Einwölbung 5 sind Leiterbahnen 4 aufgebracht.

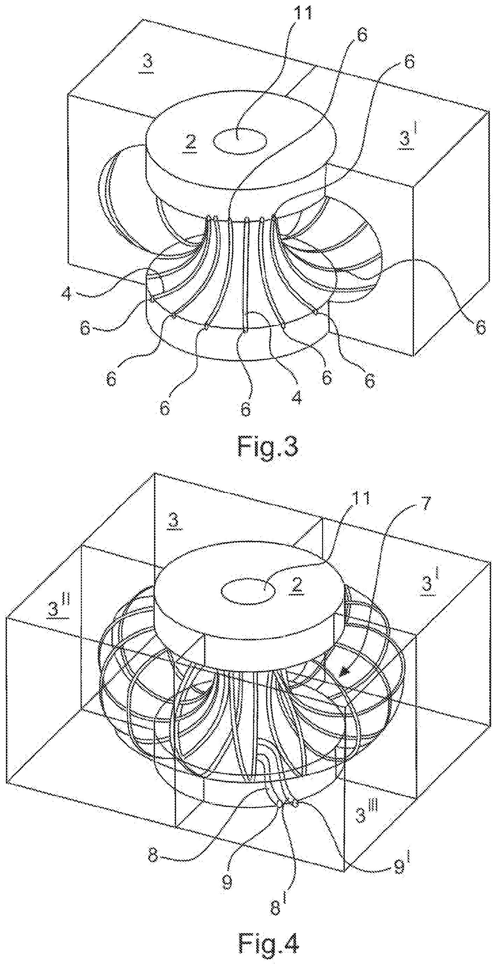

An den Enden der jeweiligen Leiterbahnen 4 sind Kontaktstellen 6 angebracht. Diese Kontaktstellen 6 sind nur exemplarisch in den Figuren 2a und 2b dargestellt. Die Kontaktstellen haben einen größeren Flächeninhalt als der Flächeninhalt des Leiterbahnquerschnitts. Über die Kontaktstellen 6 werden die einzelnen Leiterbahnen 4 miteinander elektrisch kontaktiert. Wenn die Segmente 2, 3, 3', 3", 3'" zusammengefügt sind, passen die Kontaktstellen 6 der zusammengehörigen Leiterpaare zueinander. Wenn alle Segmente 2, 3, 3', 3", 3'" zusammengefügt sind, bilden die kontaktierten Leiterbahnen 4, wie in Figur 4 zu sehen, eine Ringspule 7 aus.

Ein Außensegment 3'" weist zwei Durchgänge 8, 8' auf. Bei einem solchen Durchgang handelt es sich um eine Bohrung oder eine sonstige Öffnung, die vom Hohlraum bis zu einer Austrittsfläche 9, 9' einer Außenfläche des Außensegments 3'" reicht. Die Durchgänge 8, 8' sind mit elektrisch leitendem Material beschichtet oder mit elektrisch leitendem Material gefüllt. Dadurch wird eine elektrisch leitende Verbindung zwischen einer Leiterbahn 4 bzw. der Ringspule 7 und der Austrittsfläche 9, 9' hergestellt. Über die Austrittsflächen 9, 9' kann die Ringspule 7 elektrisch abgegriffen und in einen Schaltkreis, beispielsweise in einen Rogowski-Sensorschaltkreis, integriert werden.

Das Sensormodul 1 weist eine Öffnung 11 auf, in welche ein Kontaktelement (nicht gezeigt) angeordnet sein kann. Das Sensormodul 1 kann Informationen über den Stromfluss im Kontaktelement liefern. Im Sensormodul können auch mehrere Öffnungen und zugehörige Kontaktelemente vorhanden sein. Weiterhin können auch mehrere Ringspulen im Sensormodul vorhanden sein. Durch die MID-Technik ist eine exakte und kleine Bauweise solcher Sensormodule möglich. Durch das Sensormodul ist eine Datenauswertung im Betrieb eines Steckverbinders (nicht gezeigt) möglich.

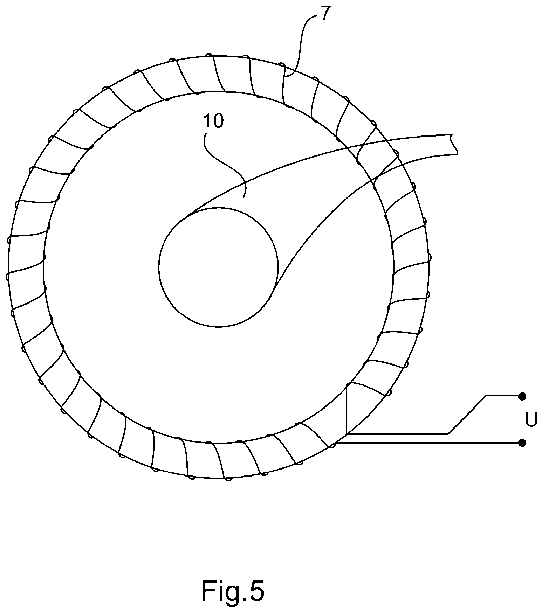

In Figur 5 ist ein mögliches Sensormessprinzip mit einer Ringspule kurz skizziert. Ein Leiter oder ein Kontaktelement 10 ist innerhalb der Ringspule 7 abgeordnet. Der durch den Leiter oder das Kontaktelement 10 fließende Wechselstrom erzeugt ein veränderliches Magnetfeld, welches in der Ringspule 7 eine Spannung U induziert. Diese Spannung U kann beispielsweise über die Austrittsflächen 9, 9' abgegriffen werden.

Im Folgenden wird die Erfindung noch einmal kurz zusammengefasst: Die Erfindung betrifft ein Sensormodul für einen modularen Steckverbinder, wobei das Sensormodul 1 aus einem Kernsegment 2 und zumindest zwei darum angeordneten Außensegmenten 3, 3', 3", 3'" besteht, wobei die Segmente 2, 3, 3', 3", 3'" im zusammengesetzten Zustand miteinander einen Hohlraum einschließen. Im Holhraum sind Leiterbahnen 4 mithilfe der MID-Technik aufgebracht, wobei alle Leiterbahnen 4 im verbundenen Zustand zusammen die Form einer Ringspule (7) ausbilden. Die Ringspule kann nach dem Rogowski-Prinzip in einer Sensorschaltung den Stromfluss eines Kontaktelementes messen, welches ebenfalls im Sensormodul integriert ist.

**Bezugszeichenliste**

| | | | |
|---|---|---|---|
| 1 | Sensormodul | 11. | Öffnung |
| 2 | Kernsegment | | |
| 3 | Außensegment | | |
| 4 | Leiterbahn | | |
| 5 | Einwölbung | | |
| 6 | Kontaktstelle | | |
| 7 | Ringspule | | |
| 8 | Durchgang | | |
| 9 | Austrittsfläche | | |
| 10 | Leiter / Kontaktelement | | |
| | | | |
| U | Spannung | | |

## Patentansprüche

1. Sensormodul für einen modularen Steckverbinder,
wobei innerhalb des Sensormoduls eine Ringspule angeordnet ist, die zur Messung von Wechselströmen verwendbar ist
**dadurch gekennzeichnet,**
- **dass** das Sensormodul (1) aus einem hantelförmigen Kernsegment (2) und aus zwei oder vier um das Kernsegment (2) angeordneten Außensegmenten (3, 3', 3", 3"') besteht,
- **dass** die Segmente (2, 3, 3', 3", 3"') im zusammengesetzten Zustand miteinander einen Hohlraum einschließen,
- **dass** die Außensegmente (3, 3', 3", 3"') eine zum Kernsegment (2) gerichtete Einwölbung (5) aufweisen, auf deren Oberflächen jeweils mehrere Leiterbahnen (4) aufgebracht sind,
**dass** auf der Mantelfläche des Kernsegments (2) mehrere Leiterbahnen (4) aufgebracht sind,
- **dass** die einzelnen Leiterbahnen (4) jeweils Kontaktstellen (6) aufweisen, über welche eine Leiterbahn (4) eines Segments (2) mit zumindest einer Leiterbahn eines anderen Segments (3, 3', 3", 3"') elektrisch verbindbar ist,
- **dass** alle Leiterbahnen (4) im verbundenen Zustand zusammen die Form einer Ringspule (7) ausbilden.

2. Sensormodul nach Anspruch 1
**dadurch gekennzeichnet,**
**dass** der Hohlraum torusförmig ist.

3. Sensormodul nach einem der vorstehenden Ansprüche
**dadurch gekennzeichnet,**
- **dass** die einzelnen Leiterbahnen (4) jeweils zwei Kontaktstellen (6) aufweisen und
- **dass** eine Leiterbahn (4) eines Segments (2) mit zumindest zwei Leiterbahn eines anderen Segments (3, 3', 3", 3"') elektrisch verbindbar ist.

4. Sensormodul nach einem der vorstehenden Ansprüche
**dadurch gekennzeichnet, dass**
die Kontaktstellen (6) flächig ausgebildet sind und einen größeren Flächeninhalt aufweisen als der Flächeninhalt der Querschnittsfläche der Leiterbahnen (4).

5. Sensormodul nach einem der vorstehenden Ansprüche
**dadurch gekennzeichnet, dass**
die sich berührenden Kontaktstellen (6) der Segmente (2, 3, 3', 3", 3"') mit einem elektrisch leitfähigen Kleber miteinander verklebt sind.

6. Sensormodul nach einem der vorstehenden Ansprüche
**dadurch gekennzeichnet, dass**
die Leiterbahnen (4) mithilfe der MID-Technik erzeugt sind.

7. Sensormodul nach einem der vorstehenden Ansprüche
**dadurch gekennzeichnet,**
- **dass** zumindest ein Außensegment (3, 3', 3", 3"') zumindest einen Durchgang (8, 8') aufweist, wobei der Durchgang (8, 8') vom Hohlraum zu einer Austrittsfläche (9, 9') einer Außenfläche des Außensegments (3, 3', 3", 3"') verläuft
- **dass** der Durchgang (8, 8') mit elektrisch leitenden Material beschichtet ist oder elektrisch leitendes Material enthält und
- **dass** über den Durchgang (8, 8') eine elektrisch leitende Verbindung zwischen einer Leiterbahn (4) beziehungsweise der Ringspule (7) und der Austrittsfläche (9, 9') besteht.

8. System aus einem Sensormodul (1) gemäß Anspruch 1 und einem modularen Steckverbinder.

## Claims

1. A sensor module for a modular plug connector,
wherein an annular coil that can be used to measure alternating currents is arranged within the sensor module
**characterized in that**
- the sensor module (1) comprises a dumbbell-shaped core segment (2) and two or four outer segments (3, 3', 3", 3"') that are arranged around the core segment (2),
- the segments (2, 3, 3', 3", 3"') in the assembled state enclose a hollow chamber
- the outer segments (3, 3', 3", 3"') comprise a concave curvature (5) that is facing the core segment (2) and in each case multiple conductor tracks (4) are applied to the surfaces of said outer segments and
- multiple conductor tracks (4) are applied to the peripheral surface of the core segment (2)
- the individual conductor tracks (4) comprise in each case contact sites (6) by way of which it is possible to connect in an electrical manner a conductor track (4) of one segment (2) to at least one conductor track of another segment (3, 3', 3", 3"') and
- all the conductor tracks (4) in the connected state together form an annular coil (7).

2. The sensor module as claimed in claim 1,
**characterized in that**
the hollow chamber is annular shaped.

3. The sensor module as claimed in any one of the preceding claims,
**characterized in**
- **that** the individual conductor tracks (4) comprise in each case two contact sites (6) and
- **that** a conductor track (4) of one segment (2) can be connected in an electrical manner to at least two conductor tracks of another segment (3, 3', 3", 3"').

4. The sensor module as claimed in any one of the two preceding claims,
**characterized in that**
the contact sites (6) are embodied in a planar manner and comprise a larger surface area than the surface area of the cross-sectional area of the conductor tracks (4).

5. The sensor module as claimed in any one of the two preceding claims,
**characterized in that**
the contacting contact sites (6) of the segments (2, 3, 3', 3", 3"') are adhered to one another by means of an electrically conductive adhesive.

6. The sensor module as claimed in any one of the preceding claims,
**characterized in that**
the conductor tracks (4) are produced with the aid of MID technology.

7. The sensor module as claimed in any one of the preceding claims,
**characterized in**
- **that** at least one outer segment (3, 3', 3", 3"') comprises at least one feed-through (8, 8'), wherein the feed-through (8, 8') extends from the hollow chamber as far as an exit surface (9, 9') of an outer surface of the outer segment (3, 3', 3", 3"'),
- **that** the feed-through (8, 8') is coated with an electrically conductive material or comprises an electrically conductive material and
- **that** an electrically conductive connection is provided between a conductor track (4) or the annular coil (7) and the exit surface (9, 9') by way of the feed-through (8, 8').

8. A system comprising a sensor module (1) as claimed in claim 1 and a modular plug connector.

## Revendications

1. Module détecteur pour un connecteur modulaire, dans lequel une bobine toroïdale, qui peut être utilisée pour mesurer des courants alternatifs, est disposée à l'intérieur du module détecteur, **caractérisé**
- **en ce que** le module détecteur (1) se compose d'un segment central en forme d'haltère (2) et de deux ou quatre segments extérieurs (3, 3', 3", 3"') disposés autour du segment central (2),
- **en ce que**, lorsqu'ils sont assemblés, les segments (2, 3, 3', 3", 3"') entourent ensemble un espace creux,
- **en ce que** les segments extérieurs (3, 3', 3", 3"') présentent un renfoncement (5) qui est dirigé vers le segment central (2) et sur les surfaces duquel sont respectivement appliquées plusieurs pistes conductrices (4),
- **en ce que** plusieurs pistes conductrices (4) sont appliquées sur la surface extérieure du segment central (2),
- **en ce que** les pistes conductrices (4) individuelles présentent respectivement des points de contact (6) par le biais desquels une piste conductrice (4) d'un segment (2) peut être reliée électriquement à au moins une piste conductrice d'un autre segment (3, 3', 3", 3"'),
- **en ce que**, lorsqu'elle sont reliées, toutes les pistes conductrices (4) forment ensemble la forme d'une bobine toroïdale (7).

2. Module détecteur selon la revendication 1, **caractérisé en ce que** l'espace creux est toroïdal.

3. Module détecteur selon l'une des revendications précédentes, **caractérisé**
- **en ce que** les pistes conductrices (4) individuelles présentent respectivement deux points de contact (6) et
- **en ce qu'**une piste conductrice (4) d'un segment (2) peut être reliée électriquement à au moins deux pistes conductrices d'un autre segment (3, 3', 3", 3"').

4. Module détecteur selon l'une des revendications précédentes, **caractérisé en ce que**
les points de contact (6) sont réalisés de manière plane et présentent une superficie plus importante que la superficie de la section transversale des pistes conductrices (4).

5. Module détecteur selon l'une des revendications précédentes, **caractérisé en ce que**
les points de contact (6) des segments (2, 3, 3', 3", 3"') qui se touchent sont collés les uns aux autres au moyen d'une colle électriquement conductrice.

6. Module détecteur selon l'une des revendications précédentes, **caractérisé en ce que**
les pistes conductrices (4) sont produites à l'aide de la technique MID.

7. Module détecteur selon l'une des revendications précédentes, **caractérisé**
- **en ce qu'**au moins un segment extérieur (3, 3', 3", 3"') comporte au moins un passage (8, 8'), dans lequel le passage (8, 8') s'étend de l'espace creux à une surface de sortie (9, 9') d'une surface extérieure du segment extérieur (3, 3', 3", 3"'),
- **en ce que** le passage (8, 8') est revêtu d'un matériau électriquement conducteur ou contient un matériau électriquement conducteur et
- **en ce qu'**une liaison électriquement conductrice entre une piste conductrice (4) ou la bobine toroïdale (7) et la surface de sortie (9, 9') est établie par le biais du passage (8, 8').

8. Système composé d'un module détecteur (1) selon la revendication 1 et d'un connecteur modulaire.
